# EUROPÄISCHE PATENTANMELDUNG

(11) **EP 1 143 255 A2**
(43) Veröffentlichungstag der Anmeldung: **10.10.2001**
(21) Anmeldenummer: 01101447.9
(22) Anmeldetag: 23.01.2001
(51) Int. Cl.: G01R 31/317

(54) **Schneller Signalwähler**

(30) Priorität: 09.02.2000 DE 10005616
(71) Anmelder: Infineon Technologies AG, 81669 München (DE)
(72) Erfinder: Ayadi, Kamel, Dr., 82178 Puchheim (DE)
(74) Vertreter: MÜLLER & HOFFMANN Patentanwälte

(57) **Zusammenfassung**

Die Erfindung betrifft einen schnellen Signalwähler (10), der mehrere parallel geschaltete Transfergatter (A₁, A₂) aufweist. Die Signaleingänge (E₁, E₂) der Transfergatter (A₁, A₂) sind mit den Eingangssignalen (in, SCKS) und Steuereingänge (C1, C2) der Transfergatter mit einem Auswahlsignal (DAMODE, DAMODE_b) beaufschlagt. Durch die Schalteigenschaften der Transfergatter lassen sich die Eingangssignale im wesentlichen ohne Verlustleistung und mit einer sehr geringen Zeitverzögerung in der Größenordnung von 20 ps auf die gemeinsame Ausgabeleitung durchschalten.

## Beschreibung

Bei dem Entwurf und der Realisierung sehr schneller DRAMs tritt das Problem auf, dass bei der Signalwahl mit herkömmlichen Multiplexern eine im Hinblick auf die kurzen Speicherzugriffszeiten solcher DRAMs kritische Zeitverzögerung zwischen den auszuwählenden Eingangssignalen und dem entsprechenden Ausgangssignal und eine hohe Verlustleistung auftritt. Diese zusätzliche Verzögerungszeit kann interne Funktionen des DRAMs stören. Durch die zusätzliche Verlustleistung kann unter Umständen der Test und die Ermittlung von Kennwerten des DRAM-Produkts wenn nicht unmöglich so doch erschwert werden.

In der Einbrennphase werden die meisten der im DRAM integrierten Transistoren einer thermisch-elektrischen Belastung ausgesetzt. Dabei wird das DRAM im sogenannten DA-Modus (DA-mode) betrieben. Damit soll erreicht werden, dass die Schwellenspannung V_{TH} eines frischen Transistors über eine zweijährige Betriebszeit hinweg konstant bleibt. Dies lässt sich während der Einbrennphase durch das toggling der Transistorgates mit einem regelmäßigen Taktsignal in wenigen Stunden erreichen.

Es ist somit Aufgabe der Erfindung, einen schnellen Signalwähler, insbesondere für den Einsatz innerhalb eines DRAM-Bausteins so anzugeben, dass die Zeitverzögerung zwischen den auszuwählenden Eingangssignalen und dem Ausgangssignal und die Verlustleistung minimiert sind, und dass sich während der Einbrennphase ein internes Taktsignal des DRAM-Bausteins zum toggling der Transistorgates in einfacher und kostengünstiger Weise auswählen lässt.

Diese Aufgabe wird erfindungsgemäß dadurch gelöst, dass eine Schaltungsanordnung zur Auswahl und Ausgabe eines von mehreren zugeführten Eingangssignalen auf eine Ausgabeleitung mittels eines Auswahlsignals dadurch gekennzeichnet ist, dass mehrere Transfergatter parallel geschaltet sind, dass die Signaleingänge der Transfergatter mit den Eingangssignalen und die Steuereingänge der Transfergatter mit dem Auswahlsignal beaufschlagt sind und dass die Ausgangsanschlüsse der Transfergatter miteinander und mit der Ausgabeleitung verbunden sind.

Eines der auszuwählenden Eingangssignale kann ein internes Taktsignal sein, mit dem die Transistorgates des DRAM-Bausteins während der Einbrennphase zum toggling beaufschlagt werden.

Die vorgeschlagene Schaltungsanordnung bietet den Vorteil, dass sie zwischen den zu wählenden Eingangssignalen und dem entsprechenden Ausgangssignal nur eine minimale Zeitverzögerung von annähernd 20 ps und praktisch keine Verlustleistung verursacht.

Die vorgeschlagenen zur Auswahl der Eingangssignale dienenden Transfergatter lassen sich einfach und kostengünstig in einer konzentrierten Interfaceschaltung im DRAM-Chip integrieren und nehmen nur eine geringe Chipfläche ein.

Eine Grundschaltung des erfindungsgemäßen schnellen Signalwählers im DRAM weist zur Auswahl von zwei Eingangssignalen zwei Transfergatter aus komplementären CMOS-Transistoren auf, und das Auswahlsignal ist ein Betriebsartsignal DAMODE. Das erste Eingangssignal ist ein internes Taktsignal, z. B. ein Taktsignal SCKS, das durch den erfindungsgemäßen schnellen Signalwähler während dem "direct acces memory modus" (DA-Mode) durch das Betriebsartwählsignal ausgewählt wird .

Durch die hohe Schaltgeschwindigkeit und die praktisch nicht vorhandene Verlustleistung der für die erfindungsgemäße Schaltungsanordnung verwendeten Transfergatter lässt sich diese nach Art eines Signalmultiplexers funktionierende Schaltungsanordnung vorteilhaft innerhalb von DRAM-Chips einsetzen.

Diese und weitere vorteilhafte Merkmale werden in der nachstehenden Beschreibung eines bevorzugten Ausführungsbeispiels der erfindungsgemäßen Schaltungsanordnung deutlich, die sich auf die beiliegende Zeichnung bezieht. Es zeigen
- Figur 1: schematisch ein Schaltbild eines bevorzugten Ausführungsbeispiels einer erfindungsgemäßen Grundschaltung mit zwei komplementären Transfergatterpaaren zur Auswahl von zwei Eingangssignalen.
- Figur 2A, 2B, 2C, 2D: graphisch Signalzeitdiagramme zur Erläuterung der Funktion des in Figur 1 dargestellten Ausführungsbeispiels der erfindungsgemäßen Schaltungsanordnung,
- Figur 3: in vergrößertem Maßstab ein Signalzeitdiagramm, das die Zeitverzögerung zwischen einem der Eingangssignale der Schaltungsanordnung in Figur 1 und dem entsprechenden Ausgangssignal veranschaulicht
- Figur 4: eine auf der Grundschaltung von Figur 1 beruhende erweiterte Signalwählschaltung und
- Figur 5: eine auf der Grundschaltung von Figur 1 beruhende komplette Interfaceschaltung eines DRAMs.

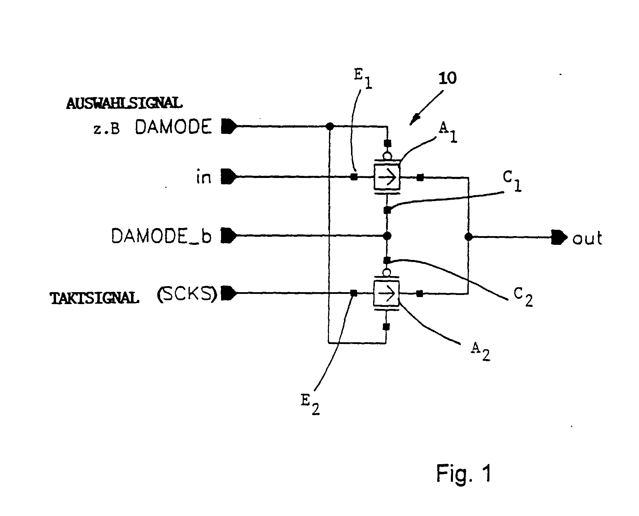

Figur 1 zeigt ein Schaltbild eines bevorzugten Ausführungsbeispiels einer mit der Bezugszahl 10 bezeichneten erfindungsgemäße Grundschaltung, das zwei parallel geschaltete aus komplementären MOS-Transistoren bestehende Transfergatter A₁ und A₂ zur Auswahl von zwei Eingangssignalen "in" und "SCKS" mittels eines Betriebsartauswahlsignals aufweist. Das Betriebsartauswahlsignal, im Beispiel DAMODE und dessen invertiertes Signal DAMODE_b, liegen jeweils Steuereingängen der Transfergatter A₁ und A₂ an. Das jeweils gewählte Eingangssignal "in" oder "SCKS" wird auf eine Ausgabeleitung "out" geschaltet.

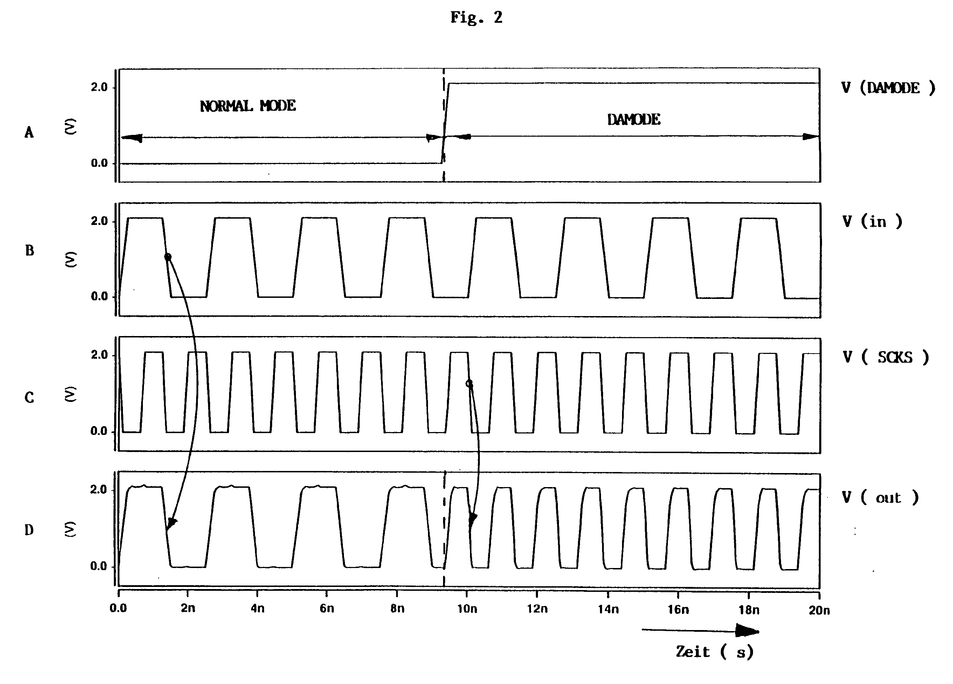

Figur 2A, 2B, 2C und 2D zeigt Signalzeitdiagramme zur Erläuterung der Funktion der in Figur 1 dargestellten Grundschaltung 10. Die obere Zeile (Figur 2A) zeigt das Auswahlsignal DAMODE. Mit dem hohen Zustand des Auswahlsignals DAMODE schaltet der in Figur 1 dargestellte Signalwähler das am Eingang E₂ des unteren Transfergatters A₂ anliegende Taktsignal SCKS (Figur 2C) durch und legt dieses auf die Ausgabeleitung "out", während der tiefe Zustand des Auswahlsignals DAMODE, der in Figur 1 und Figur 2 mit DAMODE_b bezeichnet ist, das am Eingang E₁ des ersten Transfergatters A₁ liegende Eingangssignal "in" (Fig. 2B) durchschaltet und auf die Ausgabeleitung "out" legt. Diese Funktion ist aus Fig. 2D ersichtlich.

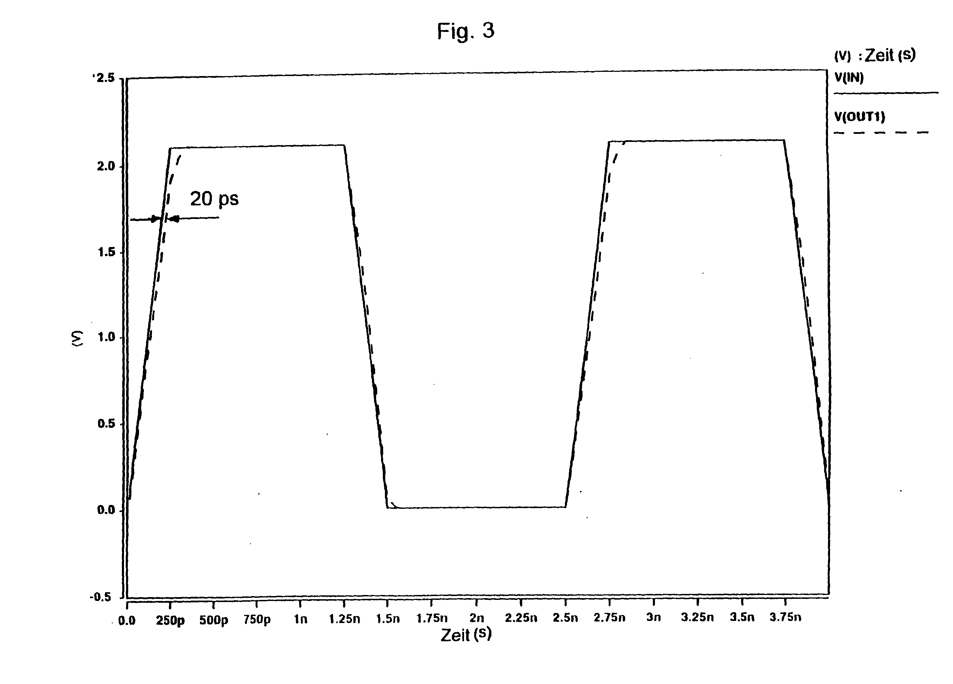

Aufgrund der schnellen Schaltzeit der für den erfindungsgemäßen Signalwähler eingesetzten Transfergatter wird, wie Figur 3 zeigt, nur eine geringfügige Zeitverzögerung von etwa 20 ps zwischen dem jeweiligen Eingangssignal und dem Ausgang der Transfergatter A₁ und A₂ verursacht. Diese hohe Geschwindigkeit macht die in Figur 1 dargestellte Grundschaltung 10 besonders geeignet zum Hin- und Herschalten (für das toggling) von im DRAM integrierten Transistoren während der Einbrennphase.

Testversuche und eine Simulation haben gezeigt, dass ein bei der Anmelderin entwickeltes DRAM mit einer Speicherkapazität von 288 Mbits und einer Taktfrequenz von 800 MHz mit dem erfindungsgemäßen schnellen Signalwähler korrekt arbeitet. Mit dieser Signalwählschaltung ist eine sonst bei herkömmlichen Multiplexern auftretende Zeitverzögerung zwischen einem Eingangssignal und dem entsprechenden Ausgangssignal ohne Belang.

Der erfindungsgemäße schnelle Signalwähler ermöglicht dieses Hin- und Herschalten (toggling) der Transistorgates mittels des internen SCKS-Taktes im hohen Zustand des Auswahlsignals DAMODE während der Einbrennphase, die drei bis zehn Stunden dauert.

Nach dieser impulsförmigen Belastung der Transistoren im DRAM bleibt V_{TH} über lange Zeit > 2 Jahre konstant und steigert dadurch die Arbeitsqualität des DRAM.

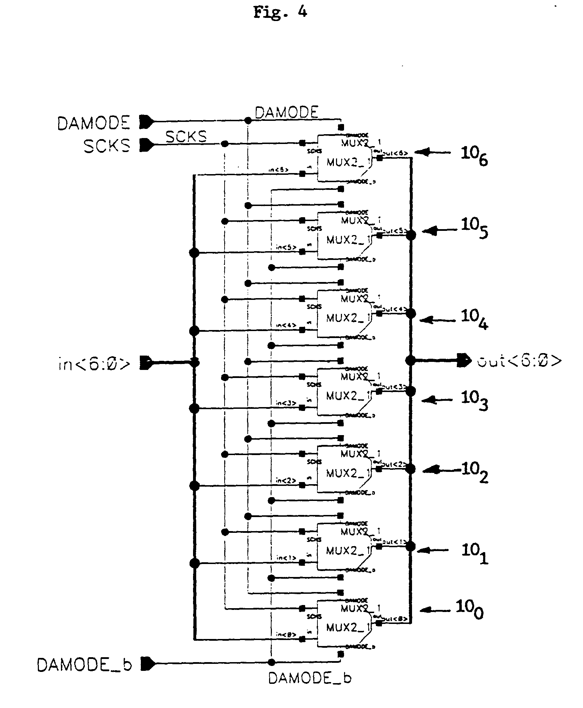

Die in Figur 1 gezeigte Grundschaltung 10 des erfindungsgemäßen schnellen Signalwählers ermöglicht eine Anwendung, bei der der Takt SCKS auf einen Bus aufgeschaltet wird. Diese Anwendung ist in Figur 4 dargestellt.

In der in Figur 4 dargestellten erweiterten Signalwählschaltung ist jede der mit 10₀ bis 10₆ bezeichneten Signalwählschaltungen durch die in Figur 1 gezeigte Grundschaltung 10 repräsentiert. Über eine Busleitung "in" <6:0>, die sich auf sämtliche erste Eingänge der Signalwählschaltung 10₀ bis 10₆ verteilt, können im Normal-mode sieben Signale auf einen Ausgangsbus "out" <6:0> geschaltet werden. Die gesamte Schaltung wird vom Auswahlsignal DAMODE und dessen invertiertem Signal DAMODE_b gesteuert. Während DAMODE wird SCKS auf den Ausgangsbus gelegt.

Funktionell und schaltungstechnisch ist jede der in Figur 4 gezeigten Signalwählschaltungen 10₀ bis 10₆ identisch mit der in Figur 1 dargestellten Grundschaltung 10. Wenn DAMODE in tiefem Zustand ist (DAMODE_b ist hoch), wird "in" <6:0> auf die Ausgabebusleitung "out" <6:0> geschaltet. Wenn dagegen das Auswahlsignal DAMODE hoch ist, wird das interne Taktsignal SCKS auf die Ausgabebusleitung "out" <6:0> gelegt.

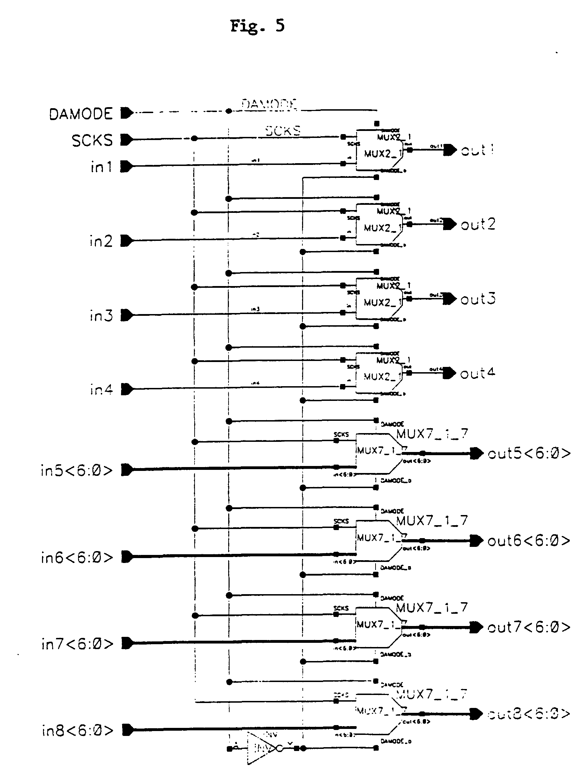

Figur 5 zeigt ein Schaltbild einer vollständigen Interfaceschaltung für die Anwendung zum Aufschalten des internen Taktes SCKS auf die Transistorgates während der Einbrennphase des DRAM, die auf der in Figur 1 gezeigten Grundschaltung eines erfindungsgemäßen schnellen Signalwählers beruht. Diese Interfaceschaltung enthält vier Grundschaltungen 10 gemäß Figur 1, die mit MUX₂₋₁ symbolisiert sind, und vier erweiterte Signalwählschaltungen gemäß Figur 4, die mit MUX₇₋₁ symbolisiert sind. In dieser Interfaceschaltung wird, wenn das Auswahlsignal DAMODE hoch liegt, durch den Takt SCKS mit einer Verzögerungszeit von etwa 20 ps hin- und hergeschaltet (getoggelt). Wenn das Auswahlsignal DAMODE tief liegt, werden die Eingänge "in" an ihre jeweiligen Ausgänge gelegt.

Allgemein müssen, um mit der in Fig. 1 gezeigten Grundschaltung 10 arbeiten zu können, die Eingangssignale und das Taktsignal SCKS lediglich ausreichend verstärkt sein, dass sie durch die Transfergatter ohne Dämpfung und ohne jede zusätzliche Verzögerungszeit durchgeschaltet werden können.

Die obige Beschreibung macht dem einschlägigen Fachmann deutlich, dass die in Fig. 1 dargestellte Grundschaltung eines schnellen Signalwählers viele verschiedene Schaltungskombinationen möglich macht, dass jedoch deren Funktion dieselbe ist, wie bei der in Fig. 1 gezeigten Grundschaltung.

Die in Figur 1 gezeigte Grundschaltung 10 eines erfindungsgemäßen schnellen Signalwählers läßt sich auch bei anderen Betriebsarten beim Einbrennen eines DRAM verwenden, z.B. im sogenannten DROWSY-MODE. Dann ersetzt das DROWSY-MODE-Signal einfach das Auswahlsignal DAMODE bei den in den Figuren 1, 4 und 5 dargestellten Schaltungsanordnungen.

Die korrekte Funktion wurde durch Simulation in Normal-mode tests und in DA-Mode tests verifiziert.

## Patentansprüche

1. Schaltungsanordnung zur Auswahl und Ausgabe eines von mehreren zugeführten Eingangssignalen (in, SCKS) auf eine Ausgabeleitung (out) mittels eines Auswahlsignals (DAMODE, DAMODE_b),
**dadurch gekennzeichnet, dass**
mehrere Transfergatter (A₁, A₂) parallel geschaltet sind, **dass** die Signaleingänge (E₁, E₂) der Transfergatter (A₁, A₂) mit den Eingangssignalen (in, SCKS) und die Steuereingänge (C₁, C₂) der Transfergatter (A₁, A₂) mit dem Auswahlsignal (DAMODE, DAMODE_b) beaufschlagt sind und **dass** die Ausgangsanschlüsse (O₁, O₂) der Transfergatter (A₁, A₂) miteinander und mit der Ausgabeleitung (out) verbunden sind.

2. Schaltungsanordnung nach Anspruch 1,
**dadurch gekennzeichnet, dass**
eine Grundschaltung (10) zur Auswahl von zwei Eingangssignalen (in, SCKS) zwei Transfergatter (A₁, A₂) aus komplementären MOS-Transistoren aufweist.

3. Schaltungsanordnung nach Anspruch 2,
**dadurch gekennzeichnet, dass**
die beiden Transfergatter (A₁, A₂) zur Auswahl von Signalen in einem DRAM-Baustein vorgesehen sind, wobei ein erstes Eingangssignal als ein internes Taktsignal (SCKS) des DRAM während einer Einbrennphase in einer Direktzugriffs-Betriebsart (DA-Modus) durch ein Betriebsartwählsignal DAMODE und das zweite Eingangssignal (in) während einer Normalbetriebsart des DRAM-Bausteins auf die Ausgabeleitung (out) geschaltet wird.

4. Schaltungsanordnung nach einem der vorangehenden Ansprüche,
**dadurch gekennzeichnet, dass**
die Signalpegel der Eingangssignale und die Transfergatter (A₁, A₂) so eingerichtet sind, **dass** eine minimale Verzögerung zwischen den Eingangssignalen (in, SCKS) und dem Ausgangssignal gewährleistet ist.

5. Schaltungsanordnung nach Anspruch 4,
**dadurch gekennzeichnet, dass**
die Verzögerungszeit zwischen den Eingangssignalen und dem Ausgangssignal annähernd 20 ps beträgt.
